# EUROPEAN PATENT SPECIFICATION

(11) **EP 3 836 197 B1**
(45) Date of publication and mention of the grant of the patent: **17.06.2026**
(21) Application number: 19214527.4
(22) Date of filing: 09.12.2019
(51) Int. Cl.: H10D 30/01, H10D 62/10, H10D 30/43, H10D 30/67, H10P 90/00, H10W 10/10, H10W 10/17, H10W 10/00, B82Y 10/00

(54) **METHOD OF FORMING AND ISOLATING A SEMICONDUCTUR DEVICE**
VERFAHREN ZUM FORMEN UND ISOLIEREN EINES HALBLEITERBAUELEMENTS
PROCÉDÉ DE FORMATION ET D'ISOLATION D'UN DISPOSITIF SEMICONDUCTEUR

(43) Date of publication of application: 16.06.2021
(73) Proprietor: Imec VZW, 3001 Leuven (BE)
(72) Inventor: CHAN, Boon Teik, 3001 Leuven (BE); DENTONI LITTA, Eugenio, 3001 Leuven (BE); ZHANG, Liping, 3001 Leuven (BE)
(74) Representative: AWA Sweden AB

(56) References cited:
- US-A1- 2019 288 117
- US-A1- 2019 296 151
- US-B1- 10 332 803
- US-B1- 10 461 154

## Description

### Technical field

The present inventive concept relates to of field of semiconductor devices.

More particularly it relates to a method of forming and isolating a semiconductor device comprising horizontally stacked nanosheets.

### Background

In the strive to provide even more power- and area-efficient circuit designs, new transistor devices are being developed.

Horizontal channel field effect transistor (FET) devices include the finFET, which has a gate straddling a channel portion of a fin-shaped semiconductor structure, and the horizontal nanowire- or nanosheet-FET (horizontal NWFET or NSFET), which has a gate at least partly enclosing a channel portion of a horizontally oriented nanowire- or nanosheet-shaped semiconductor structure.

Efficient process flows dedicated to fabrication of horizontal channel FET devices have been developed. However, individual horizontal channel field effect transistors need to be positioned close to each other to have area-efficient design, and there may thus be a challenge to efficiently isolate adjacent transistors from each other and to form a bottom isolation. Thus, there is a need in the art for improved methods of forming and isolating semiconductor devices.

US 2019/296151 A1 discloses a method for fine-tuning a threshold voltage of a nanosheet structure. The method includes forming an oxide within a cavity or gap created by removing a first SiGe alloy layer from a vertical nanosheet stack.

US 10 461 154 B1 discloses a method of forming nanosheets that includes providing at least two stacks of semiconductor material layers on a supporting bulk substrate. A first undercut region filled with a first dielectric material is formed extending from the opening into the bulk semiconductor substrate underlying the semiconductor material layers of the stacks of semiconductor material layers. A second undercut region into the bulk semiconductor substrate filled with a second dielectric material from a side of the at least two stacks of semiconductor material layers that is opposite a side of the at least two stacks of semiconductor material layer at which the first undercut region is positioned.

US 2019/288117 A1 discloses a method for forming a gate-all-around transistor, comprising: forming an opening to separate a semiconductor channel material into a pair of semiconductor channel structures, wherein the opening includes a first portion between the pair of semiconductor channel structures and a second portion beneath the pair of semiconductor channel structures; forming a spacer support within the opening, the spacer support having a first portion thereof positioned underneath and a second portion thereof positioned alongside a first portion of the pair of semiconductor channel structures; forming a source/drain terminal adjacent an end of the pair of semiconductor channel structures; and forming a gate metal surrounding a second portion of the pair of semiconductor channel structures adjacent to the first portion of the pair of semiconductor channel structures, wherein the spacer support is positioned between the source/drain terminal and the gate metal.

US 10 332 803 B1 discloses methods for forming gate-all-around transistors using selective patterning techniques.

### Summary

It is an object of the invention to at least partly overcome one or more limitations of the prior art. In particular, it is an object to provide a method allowing for an efficient isolation of semiconductor devices formed on the same substrate.

As a first aspect of the invention, there is provided a method of forming a semiconducting device, said method comprising the steps of
a) forming, on a substrate surface, a stack of horizontally stacked nanosheets in the form of a fin, said stack comprising semiconductor material sheets and a bottom semiconductor nanosheet:
b) forming a trench through said stack vertically down through said bottom semiconductor nanosheet; thereby separating the fin into two sub-fins and the stack into two substacks;
c) selectively removing said bottom semiconductor nanosheet, thereby forming a bottom space extending under said substacks;
d) simultaneously filling said bottom space and said trench with the same dielectric material to provide a bottom isolation and formation of a dielectric wall between said substacks.

As used herein, the term vertical denotes a direction being parallel to a vertical geometrical axis extending perpendicular to the substrate. The terms "above", "below", "upper", "top", "lower" "bottom" are thus used to refer to relative positions along the vertical axis, and does hence not imply an absolute orientation of the substrate or device. In addition, the term lateral or horizontal refers to the direction perpendicular to the vertical direction, i.e. to the direction parallel to the substrate surface.

The first aspect of the invention is based on the insight that the isolation between individual substacks of nanosheets, i.e. forming a dielectric "wall" between substacks of nanosheets, can be performed simultaneously as providing the bottom isolation. Thus, both bottom and wall isolation may be filled with the same dielectric material.

The bottom isolation, i.e. the isolation filling the bottom space, separates the substacks of nanosheets from the substrate.

The substrate surface may be the surface of a semiconductor material, such as a single crystalline, polycrystalline or amorphous semiconductor material. As an example, the substrate may be single crystalline silicon.

The stack of horizontally stacked nanosheets may be used to form horizontal channel FET devices, i.e. devices comprising a semiconductor structure comprising a first and a second source/drain portion and a channel portion located intermediate and extending horizontally between the first and second source/drain portions, and further comprising a gate structure extending horizontally along the channel portion. In a horizontal channel FET device, the first and second source/drain portions and the channel portion may intersect a common horizontal plane. The channel portion is adapted to (in use of the device) conduct a horizontally oriented flow of charge carriers between the source/drains.

The semiconductor material sheets of the stack formed in step a) may thus be arranged to be used as channels in a formed horizontal channel FET device.

The bottom semiconductor nanosheet may be arranged on the substrate surface. However, there may be intermediate layers other than horizontally stacked nanosheets between the substrate surface and the bottom semiconductor nanosheet.

The bottom semiconductor nanosheet may comprise silicon germanium (SiGe). The other semiconductor nanosheets of the stack may be of a material such that the bottom semiconductor nanosheet can be selectively removed from the other sheets during step c).

In embodiments of the first aspect, the bottom semiconductor nanosheet comprises SiGe having a Ge content of over 50%, i.e. Si₁₋ₓGeₓ, in which x>0.5. As an example, the bottom semiconductor nanosheet may be a Si_{0.35}Ge_{0.65} nanosheet.

Moreover, the other semiconductor nanosheets of the stack comprises SiGe sheets having a Ge content of below 40%.

It has been found that Si₁₋ₓGeₓ nanosheets, in which X>0.5, may be selectively removed from other Si₁₋ₓGeₓ nanosheets, in which X<0.4 during step c) of the method of the first aspect. Thus, these materials allow of selectively removing the bottom semiconductor nanosheet after forming the trench, thereby allowing for simultaneous fill of the same dielectric material in the trench and in the bottom space extending under the substacks formed when forming the trench.

The formation of the trench in step b) may be a straight etch through the stack, e.g. using anisotropic etching, i.e. orientation dependent etching, of an exposed upper lateral surface area of the stack.

The stack provided in step a) may thus be in the form of fins that are cut into two individual substacks by the trench in step b).

In embodiments of the first aspect, the stack formed in step a) comprises an upper insulator layer above the semiconductor material sheets. Such an upper insulator layer may originate from the patterning of the stack, i.e. from the patterning of the fins. The upper insulator layer may be a hardener. As an example, the upper insulator layer may comprise Si₃N₄. The upper insulator layer may thus be a hardmask, e.g. used as a CMP stopping layer.

Moreover, the stack formed in step a) may further comprise a top oxide layer. Also such a top oxide layer may originate from the formation of the horizontally stacked nanosheets. As an example, the top oxide layer may be hardmask during a lithographic patterning of the stacks on the substrate surface. The top oxide layer may comprise or consist of SiO₂.

The method may comprise the deposition of an STI (shallow trench isolation) oxide such that the semiconductor nanosheets are attached to this STI oxide during the removal of the bottom semiconductor nanosheet in step c). Such an STI oxide may thus be deposited before step c). The STI oxide may for example be silicon dioxide.

In embodiments of the first aspect, step a) further comprises lining said stack with an insulator material and depositing an STI oxide conformally to the lined sidewalls of the stack, such that said stack is held together by said STI oxide during step c).

The lining of the insulator material may be performed using atomic layer deposition (ALD). The lining may thus comprise a deposition of an insulator material on the sidewalls and on top of the stack, such as on top of the top oxide layer. The insulator material used for lining may for example be the same as the upper insulator layer. As an example, the insulator material may be Si₃N₄. Lining the stack with an insulator layer may decrease the risk of or prevent oxidation. As an example, the insulator liner may prevent oxidation on SiGe, e.g. during FCVD oxide annealing.

Depositing of the STI oxide may be performed using chemical vapor deposition (CVD), such as flowable chemical vapor deposition (FCVD). This STI oxide may thus support the nanosheets during the formation of the trench and during the selective removal of the bottom semiconductor nanosheet.

After deposition of the STI oxide, the semiconductor structure may be planarized, i.e. the height may be reduced. As an example, the planarization may remove the top oxide layer.

Forming the trench in step b) may performed using different approaches.

In embodiments, step b) comprises the steps of
b11) planarizing the formed structure after STI oxide deposition such that the upper insulator layer above said semiconductor material sheets is the uppermost layer of the stack;
b12) forming a patterned photoresist layer over the upper insulator layer such that an opening in said photoresist layer is positioned vertically over the stack; and
b13) forming a trench through said stack vertically down through said bottom semiconductor nanosheet at the position of said opening; thereby separating the stack into two substacks.

Consequently, forming the trench of step b) may include lithography and etching.

The planarizing in step b11) may be performed using chemical mechanical polishing (CMP).

Step b12) may include forming a hardmask on the planarized structure and thereafter depositing a first sacrificial layer such as a spin-on-carbon (SOC) layer, and a second sacrificial layer, such as a spin-on-glass (SOG) layer. Thereafter a photoresist layer may be formed and patterned, using a pattern of irradiation as known in the art. The photoresist layer may comprise a hardmask.

Etching may then be performed at the areas exposed in the pattern. Thus, the vertical opening of step b) may include etching processes, such as a straight etch process through vertically down through the stack and the bottom semiconductor nanosheet at the position of the opening formed after lithography.

In embodiments of the first aspect, step b) comprises
b21) planarizing the formed structure after STI oxide deposition such that the upper insulator layer above said semiconductor material sheets is the uppermost layer of the stack;
b22) removing said upper insulator layer such that said deposited STI oxide forms vertically extending sidewalls at the side of said stack;
b23) depositing spacer material over said stack and at the vertically extending sidewalls, thereby defining a horizontal gap over said stack; and
b24) forming a trench through said stack vertically down through said bottom semiconductor nanosheet at the position of said horizontal gap; thereby separating the stack into two substacks.

Consequently, as an alternative, the trench may be formed without using lithography. In the above embodiment, the trench formed in the stack is "self-aligned", meaning that also the subsequently formed dielectric wall between the substacks may be self-aligned.

The planarizing of step b21) may for example be performed using chemical mechanical polishing (CMP).

The removal of the upper insulator layer in step b22) may be performed using an acid, such as phosphoric acid (H₃PO₄). Thus, the upper insulator layer may be removed early in the process, i.e. before formation of the trench. After removal of the upper insulator layer, the deposited STI thus forms vertically extending portions extending over the stack The vertically extending portions may extend all around the stack, thereby forming a continuous vertically extending portion around the stack. The vertically extending portions may also be formed so that they extend on two opposite sides of the stack, as seen in a cross-section through the stack.

The height above the stack of the vertically extending portions may be lower than the horizontal width of the stack.

Examples of deposition processes that can be used in depositing the spacer material include, for example, CVD, PVD, PECVD or atomic layer deposition (ALD). Plasma Enhanced Atomic Layer Deposition (PEALD). The spacer material may for example be an oxide, such as SiO₂.

The spacer material is deposited at vertically extending sidewalls such that a small lateral gap is left between the vertical extending structures. This gap is positioned vertically over the stack. As an example, the gap may be positioned substantially in the middle of the stack, such that the subsequent etching in the gap in step b24) divides the stack into two sub stacks of substantially the same size. The depositing of spacer material of step b23) may comprise a first deposition of spacer material, followed by a spacer etch. The spacer etch may include an anisotropic etch to remove spacer material that has been deposited on horizontal surfaces.

An example of etching that may be used for etching the deposited spacer material is reactive-ion etching RIE.

Furthermore, before performing steps b21) to b24) above, the upper insulator layer may be trimmed in order to reduce the width of this layer before STI deposition. Thus, the lateral distance of the subsequently conformally deposited STI oxide will be shorter over the stack, meaning that after removal of the upper insulator layer in step b22), the vertically extending portion will be arranged closer to each other compared to if no trimming is performed.

Consequently, step a) may further comprise trimming the sidewalls of said upper insulator layer such that the upper insulator layer has a width that is smaller than the width of the semiconductor material sheets of the stack, said trimming being performed before lining said stack with an insulator material.

Such a step of trimming may allow for a higher aspect ratio of the subsequently formed dielectric wall between the substacks, i.e. the width of the dielectric wall may be reduced.

The simultaneous filling of the bottom space and the trench in step d) is performed using the same dielectric material. The dielectric material may comprise a silicon nitride (SiN) based material, a silicon carbon oxide (SiCO)-based material, silicon carbonitride (SiOCN, SiON), or silicon carbide (SiC).

As an example, the dielectric material of step d) may be selected from the group consisting of comprises Si₃N₄, SiCO and SiO₂. As an example, the dielectric material may be Si₃N₄.

In embodiments of the first aspect, the method further comprises a step e) of planarizing the isolated substacks of step d).

Such a planarization may be performed using chemical mechanical polishing (CMP).

In embodiments of the first aspect, the method further comprises forming gates around the substacks.

The method may first comprise removing sacrificial layers that are present in the substacks between the semiconductor nanosheets.

The gates may be formed such that they at least partly wrap around the semiconductor nanosheets of the substacks. As an example, gate structures may be formed such that they fully wrap around the released semiconductor nanosheets of the substacks, i.e. the released cannel portions. In other words, the distance between semiconductor nanosheets in the substacks may allow for forming a gate-all-around (GAA) structure, which may reduce the operating voltage of the FET device.

As an example, the gate around a first substack may be a p-gate and the gate around a second substack may be an n-gate.

Forming the gates may thus comprise forming a p-type effective work function metal, WFM, on the first and second substacks. Forming the gates may further comprise selectively removing the p-type WFM from the second substack. Then, an n-type WFM may be formed on the second substack, which may be followed by forming a first gate electrode in contact with the first substack and a second gate electrode in contact with the second substack.

Consequently, the method of the present disclosure provides for closer proximity of n-type and p-type semiconductor devices.

### Brief description of the drawings

The above, as well as additional objects, features and advantages of the present inventive concept, will be better understood through the following illustrative and non-limiting detailed description, with reference to the appended drawings. In the drawings like reference numerals will be used for like elements unless stated otherwise.
Figs. 1a and 1b are general illustrations of the approach of the present disclosure for simultaneous wall formation and bottom isolation.
Figs. 2a-2k illustrate a method according to a first embodiment for forming a semiconductor device.
Figs. 3a-3k illustrate a method according to a second embodiment for forming a semiconductor device.
Figs. 4a-4l illustrate a method according to a third embodiment for forming a semiconductor device.
Figs. 5a-c illustrate a semiconductor device with different thickness of the fins.

### Detailed description

In the above the inventive concept has mainly been described with reference to a limited number of examples. However, as is readily appreciated by a person skilled in the art, other examples than the ones disclosed above are equally possible within the scope of the inventive concept, as defined by the appended claims.

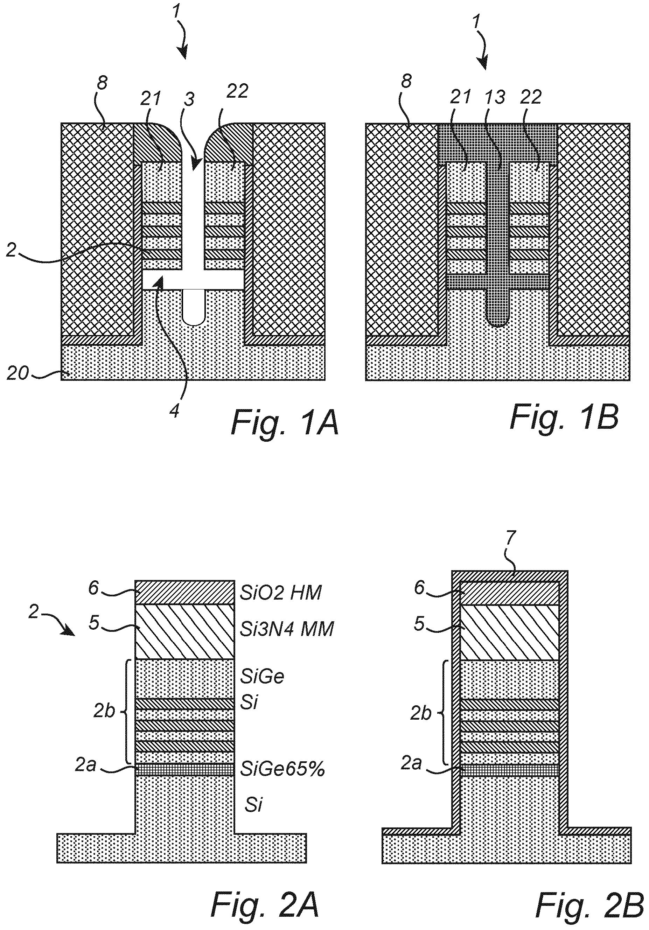

Figs. 1a and 1b shows the general approach of the present disclosure for simultaneous wall formation and bottom isolation of a semiconductor device 1 . As seen in Fig. 1, the semiconductor device comprises a stack 2 of horizontally stacked nanosheets on a substrate surface. The method comprises a step of forming a trench 3 in the stack, thereby dividing the stack 2 into two substacks 21, 22, and also selectively removing a bottom sheet to create a bottom space 4. During this procedure, the stack may be attached to e.g. an STI oxide 8. Thereafter, as illustrated in Fig. 1b, the trench 3 and the bottom space 4 may be simultaneously filled with the same dielectric material 13. Consequently, the formation of the wall between substacks and the bottom isolation may be performed while using STI oxide for holding the fins of the stack 2, instead of performing the isolation during e.g. subsequent gate patterning.

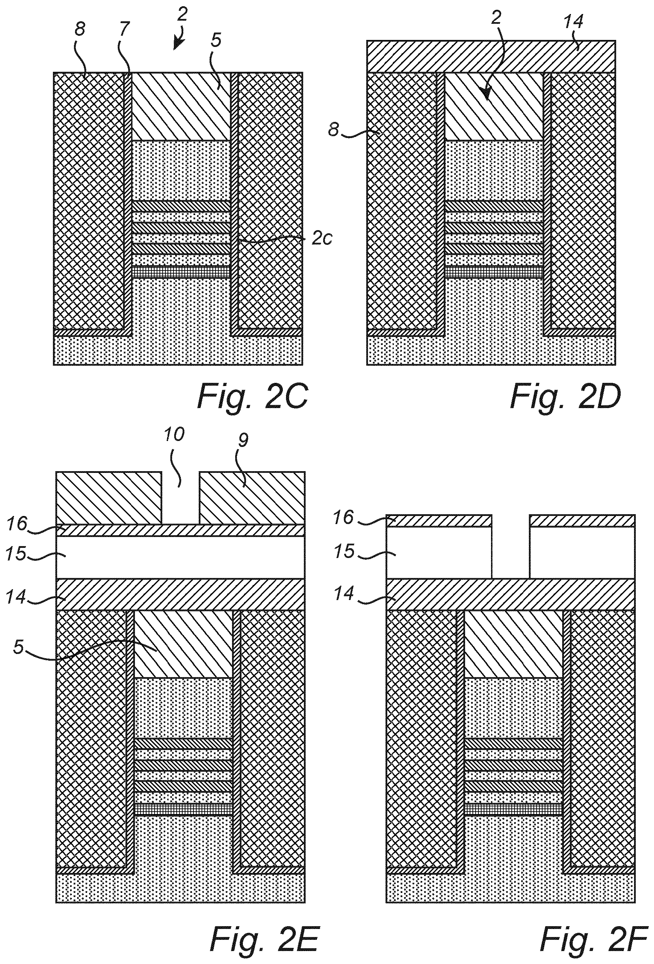

Figs. 2a-2k illustrate a method according to a first embodiment for forming a semiconductor device according to the present disclosure.

The method comprises a first step a) of forming a stack 2 of horizontally stacked nanosheets on a substrate surface 20 of Si. The stack 2 comprises semiconductor material sheets 2b and a bottom semiconductor nanosheet 2a. In this example, the bottom semiconductor nanosheet 2a is a Si_{0.35}Ge_{0.65} sheet, whereas the other semiconductor nanosheets 2b of the stack 2 comprises SiGe sheets having a Ge content of below 40%.

Between the SiGe sheets in the stack 2b, there may be sheets of a semiconductor material that are supposed to form the final channel material in the formed semiconductor device. Thus, the SiGe sheets may be sacrificial sheets that are subsequently removed. Consequently, the stack of semiconductor material sheets formed in step a) may comprise alternating SiGe sheets and sheets of another material.

As an example, the channel material of the stack 2b may be Si, and the sacrificial material may be SiGe.

Such a combination of materials may allow for selective removal of the sacrificial material while leaving the channel material.

Alternatively, the channel material of the stack 2b may be silicon germanium SiGe and the sacrificial material may be silicon Si.

Further, the channel material of the stack 2b may be silicon germanium with a first concentration of germanium Si₁₋ₓGeₓ and the sacrificial material may be silicon germanium with a second concentration of germanium, different from the first concentration Si_{1-y}Ge_{y}.

Another combination may be using germanium (Ge) as the channel material, and silicon germanium (SiGe) as the sacrificial material.

Further, some embodiments may comprise a combination of channel/sacrificial materials wherein one material is from group (or family) III in the periodic table, and the other material is from group (or family) V in the periodic table. For example, the channel material may be from group III, also known as the boron group, which comprises boron (B), aluminium (Al), gallium (Ga) and indium (In). The sacrificial material may be from group V, also known as the nitrogen group or pnictogens, which comprises nitrogen (N), phosphor (P), arsenic (As) and antimony (Sb). Alternatively, the channel material may be selected from group V and the sacrificial material selected from group III.

Furthermore, the stack 2 formed in step a) comprises an upper insulator layer 5 above said semiconductor material sheets 2b. This upper insulator layer 5 may for example be a Si₃N₄ layer, and may originate from the formation and patterning of the stack 2 on the substrate 20. A top oxide layer 6 has also been formed as the uppermost layer, which also may originate from the formation of the stack 2, e.g. during lithography. The top oxide layer 6 is in this example a SiO₂ layer. Both the upper insulator layer 5 and the top oxide layer 6.

As illustrated in Fig. 2b, the method according to the present embodiment, step a) further comprises lining the stack 2 with an insulator material 7. This may for example be performed using ALD. The stack 2 may for example be lined with Si₃N₄. The lining of the stack 2 may prevent oxidation. Moreover, as illustrated in Fig. 2c, step a) may further comprise the deposition of an STI oxide 8 and subsequent planarization using e.g. CMP. The STI oxide 8 is deposited to the lined sidewalls 2c of the stack 2 such that the stack 2 may be held together by the STI oxide 8 during a simultaneous bottom isolation and wall formation of step c). After STI deposition, the formed structure is planarized. In this example, it is planarized such that the upper insulator layer 5 is the uppermost layer of the stack 2.

As illustrated in Figs. 2d-2f, a patterned photoresist layer 9 is then formed atop of the stack such that an opening 10 in the photoresist layer 9 is positioned vertically over the stack 2. The width of the opening 10 determines the width of the trench that is subsequently formed for dividing the stack 2 into the two substacks. In this embodiment, the step of forming the opening 10 comprises depositing a hardmask layer 14, such as SiO₂, on top of the stack 2, and thereafter depositing a patterning stack which is used for patterning. As an example, the patterning stack may comprise a SoC layer 15, a SoG layer 16 and an upper photoresist 9 over the hardmask 14, which is patterned using any suitable photomask. The SoG and the SoC layers are then etched at the position of the opening 10 after removal of the photoresist layer, as illustrated in Fig. 2f.

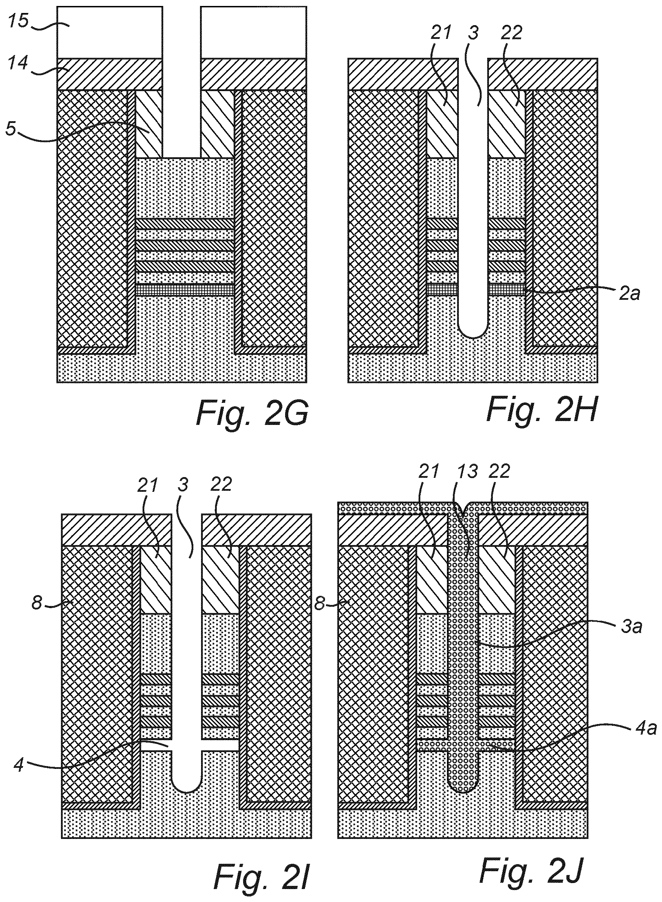

Thereafter, the hardmask 14 and the upper insulator layer 5 are etched using a suitable hard-mask open (HMO), as illustrated in Fig. 2g, before etching the trench 3 that divides the stack 2 into two substacks 21, 22, as illustrated in Fig. 2h. The etch through the stacks may be performed using any suitable anisotropic (top-down) etch, and thus divides the stack 2 into two substacks 21, 22.

Consequently, the embodiment as illustrated in Figs. 2a-h,
step b) comprises the steps of
b11) planarizing the formed structure after STI oxide deposition such that the upper insulator layer 5 above said semiconductor material sheets 2b is the uppermost layer of the stack 2;
b12) forming a patterned photoresist layer 9 over the upper insulator layer 5 such that an opening 10 in said photoresist layer 9 is positioned vertically over the stack 2; and
b13) forming a trench 3 through said stack vertically down through said bottom semiconductor nanosheet 2a at the position of said opening 10; thereby separating the stack into two substacks 21,22.

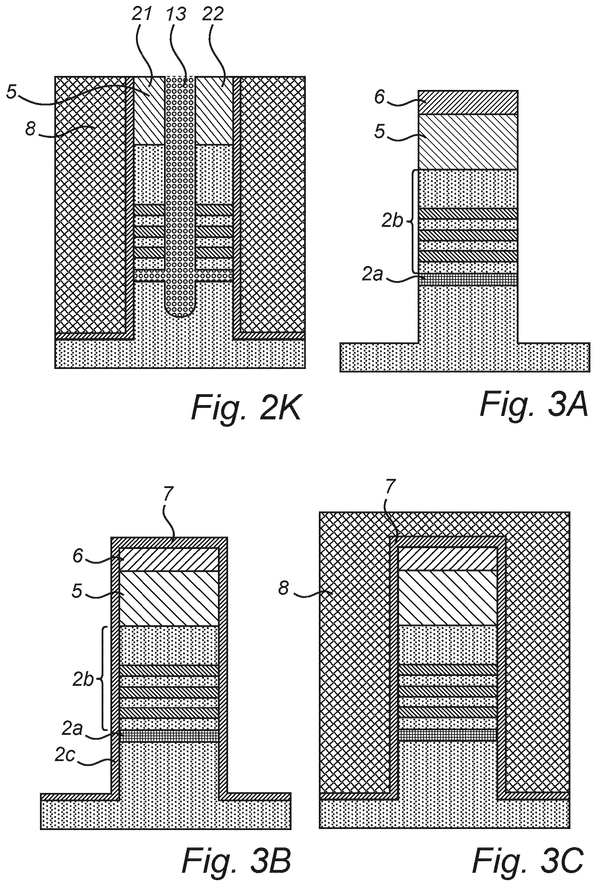

After forming the trench 3, the bottom semiconductor nanosheet 2a is selectively removed from the stack 2 in a step c) using e.g. etching based on an ammonia hydroxide-hydrogen peroxide-water mixture (APM). This is illustrated in Fig. 2i. After removal of the bottom layer 2a, a bottom space 4 is formed under the stack 2, which extends under both of the substacks 21, 22. Thereafter, as illustrated in Fig 2j, the bottom space 4 and the trench 3 are simultaneously filled in a step d) with the same dielectric material 13 to provide a bottom isolation 4a and formation of a dielectric wall 3a between said substacks 21,22. The bottom isolation 4a is thus at the filled bottom space 4 and the dielectric wall 3a is at the position of the previous trench 3. The dielectric material 13 that is deposited to form the bottom isolation 4a and the wall 3a may be selected from the group consisting of comprises Si₃N₄, SiCO and SiO₂. The deposited dielectric material 13 may then be planarized, as illustrated in Fig. 2k. Thus, both substacks 21,22 may be planarized such that the upper dielectric material 5 is the uppermost layer of the stack 2.

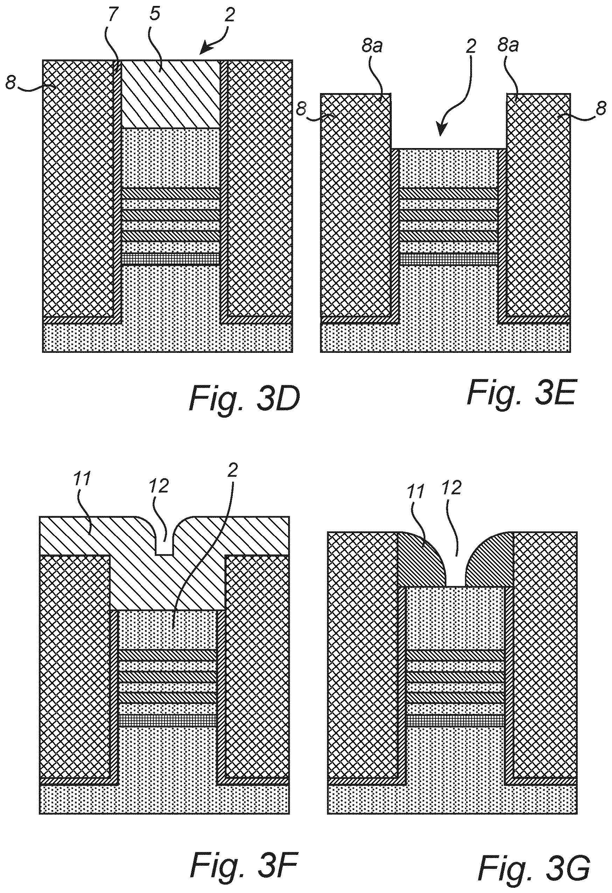

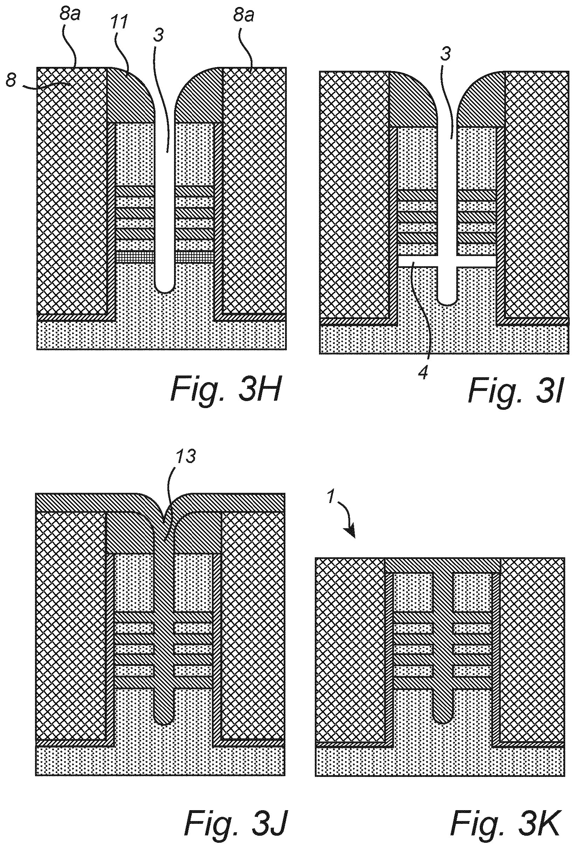

The formation of the trench 3 was in the embodiment discussed in relation to Figs 2a-2k formed by using lithography. However, other methods may be used for formation of the trench 3. Figs. 3a-3k illustrate an embodiment with "self-aligned" wall formation. As illustrated in Figs. 3a-3d, an STI oxide 8 may be deposited after lining the stack with an oxide 7, as discussed in relation to Figs. 2b and 2c above. However, before formation of the trench 3, the upper dielectric material 5, such as Si₃N₄, may be removed using e.g. phosphoric acid (H₃PO₄), as seen in Fig. 3e. In this way, vertically extending sidewalls 8a of the STI oxide 8 are formed around the remaining stack 2. Thereafter, spacer material 11 is conformally deposited over the stack 2 and the vertically extending sidewalls, as illustrated in Fig. 3f. The spacer material 11 is deposited using e.g. Plasma Enhanced Atomic Layer Deposition (PEALD) to an extend such that a horizontal gap 12 is formed between the sidewalls 8a. This gap 12 is arranged vertically above the stack 2 and thus defines the position of the trench 3 that is subsequently formed through the stack. The deposited spacer material 11 may then be etched-back, as seen in Fig. 3g, and a trench may be formed by etching the stack 2 at the position of the gap 12 formed between the deposited spacer material at the sidewalls 8a of the STI oxide 8, as seen in Fig. 3h.

Consequently, in the embodiment as illustrated in Fig. 3a-k, step b) comprises
b21) planarizing the formed structure after STI oxide 8 deposition such that the upper insulator layer 5 above said semiconductor material sheets 2b is the uppermost layer of the stack 2;
b22) removing said upper insulator layer 5 such that said deposited STI oxide 8 forms vertically extending sidewalls 8a at the side of said stack 2;
b23) depositing spacer material 11 over said stack 2 and at the vertically extending sidewalls 8a, thereby defining a horizontal gap 12 over said stack 2; and
b24) forming a trench 3 through said stack vertically down through said bottom semiconductor nanosheet 2a at the position of said horizontal gap 12; thereby separating the stack into two substacks.

Thereafter, as illustrated in Figs. 3i-k, the bottom layer 8a may be selectively removed and the trench and the bottom space 4 be filled with the same dielectric material as discussed in relation to Figs. 2i and 2j above. The formed structure may be further planarized, as illustrated in Fig. 3k.

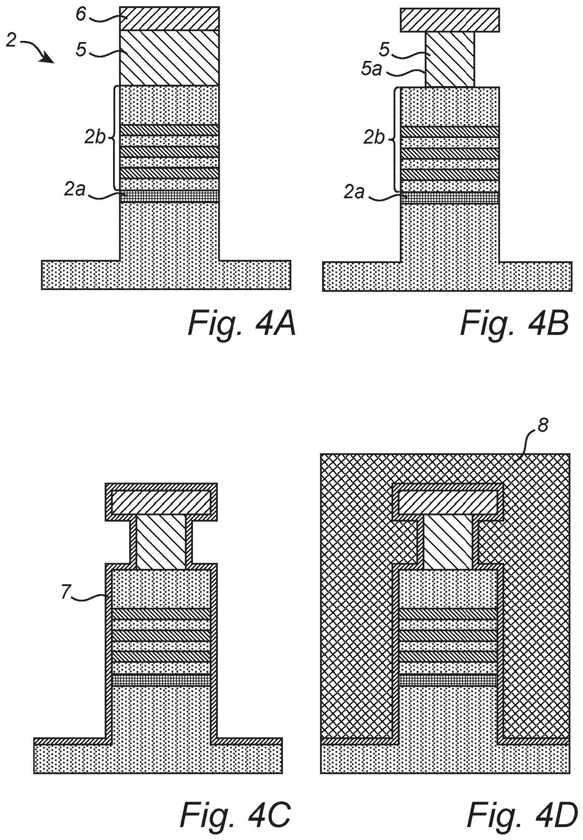

In order to increase the aspect-ratio of the dielectric wall between the two sub stacks, the upper insulator layer may be trimmed before depositing of the STI oxide. Such an embodiment is illustrated in Figs. 4a-4l, which shows a similar method for forming the trench and the isolation as discussed in relation to Figs. 3a-k above, but with an additional step of trimming the upper insulator layer 5, such as an upper Si₃N₄, layer, as illustrated in Fig. 4b, before lining the stack with a Si₃N₄ liner in Fig. 4c. The trimming of the upper insulator layer may be performed using liquid phase or gas phase isotropic etch, such as a dry gas chemical reaction with e.g. HF and NH₃.

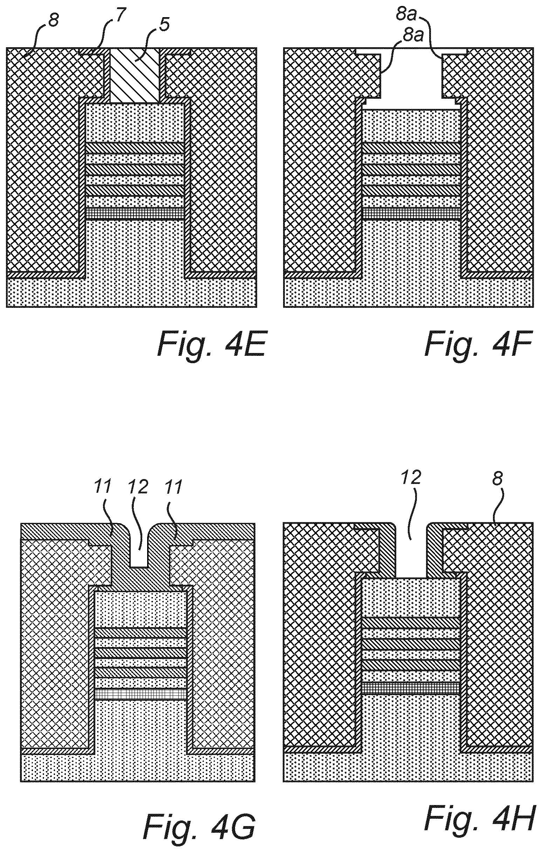

The effect of such a trimming operation is that the subsequent lining with the insulator material 7 (Fig. 4c), deposition of STI oxide 8 (Fig. 4d) and removal of the top insulator layer 5 (Fig. 4e) results in vertically extending sidewalls 8a of the STI oxide that are arranged closer to each other in the horizontal direction compared to if no trimming is performed, as illustrated in Fig. 4f.

Thus, when depositing spacer material 11 over the stack 2 and at the vertically extending sidewalls 8a, as illustrated in Fig. 4g, a thinner spacer in the horizonal direction is needed for defining the horizontal gap 12 over the stack 2, as illustrated in Figs. 4g and 4h.

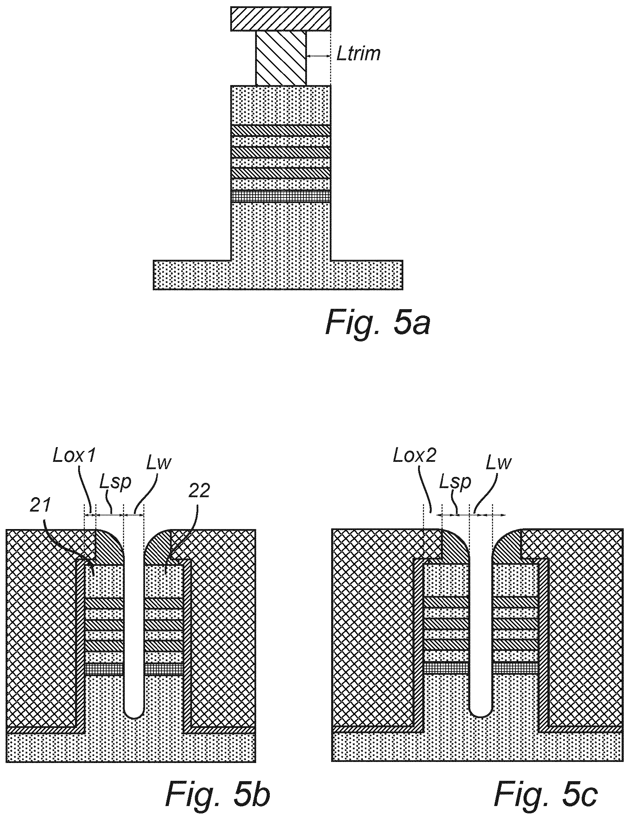

In addition, the trimming operation may be used if the stack is wide, i.e. has a larger extension in the horizontal direction. With a wide stack and no trimming, the gap 12 formed after depositing spacer material at the sidewalls would be larger if depositing the same amount of spacer material. Thus, with no trimming, the trench 3 and subsequent wall separating the two substacks would be wider. Consequently, using a trimming operation of the upper insulator layer 5, a thinner gap 12 and trench 3 may be formed. This is further illustrated in Figs. 5a-c. The width of a substack 21, 22 is the width of the STI oxide over a substack (Lₒₓ) + the width of the deposited spacer (Lₛₚ). Lₒₓ may be adjusted by the trimming operation, i.e. the more the upper insulator layer is trimmed, illustrated by Lₜᵣᵢₘ in Fig. 5a, the larger Lₒₓ becomes after STI deposition. A thin stack is illustrated in Fig. 5b and a wider stack is illustrated in Fig. 5c. In order to maintain the same wall thickness L_{w} for the larger stack of Fig. 5c with the same spacer thickness Lₛₚ, a different trimming operation can be performed to increase Lₜᵣᵢₘ and thus also Lₒₓ₂. Thus, with a different trimming, the width of the STI oxide over a substack Lₒₓ₂ of the wider stack becomes larger than the width of the STI oxide over a substack Lₒₓ₁ of the thinner stack, as illustrated in Figs. 5b and 5c.

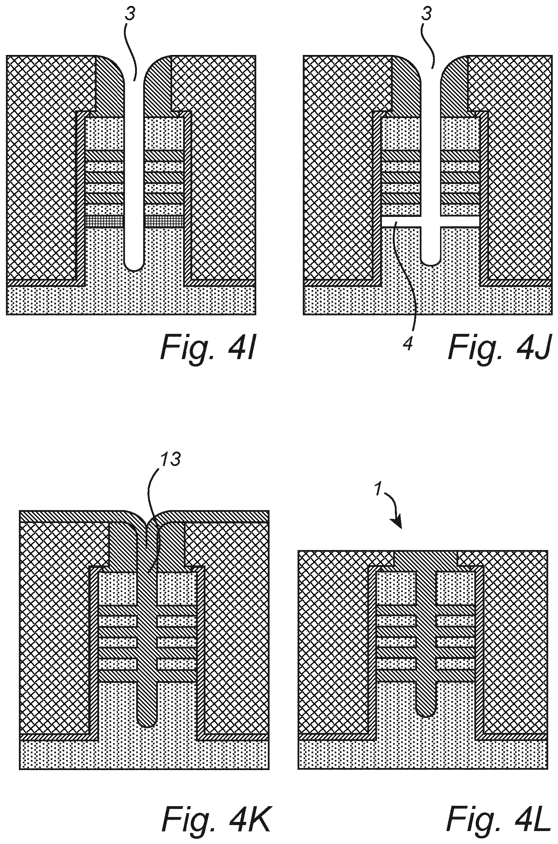

As shown in Figs. 4i-l, formation of trench 3 (Fig. 4i), selective removal of bottom sheet to form bottom space 4 (Fig. 4j), simultaneous isolation of trench 3 and bottom space 4 with dielectric material 13 (Fig. 4k) and planarization (Fig. 4l) may be performed as discussed in relation to the previous embodiments above.

Consequently, in the embodiment shown in Figs. 4a-4l, step a) further comprises trimming the sidewalls 5a of said upper insulator layer 5 such that the upper insulator layer 5) has a width that is smaller than the width of the semiconductor material sheets 2b of the stack 2, said trimming being performed before lining said stack 2 with an insulator material 7.

## Claims

1. A method of forming a semiconducting device (1), said method comprising the steps of
a) forming, on a substrate surface (20), a stack (2) of horizontally stacked nanosheets in the form of a fin, said stack comprising semiconductor material sheets (2b) and a bottom semiconductor nanosheet (2a):
b) forming a trench (3) through said stack (2) vertically down through said bottom semiconductor nanosheet (2a); thereby separating the fin into two sub-fins and the stack into two substacks (21,22);
c) selectively removing said bottom semiconductor nanosheet (2a), thereby forming a bottom space (4) extending under said substacks (21,22);
d) simultaneously filling said bottom space (4) and said trench (3) with the same dielectric material (13) to provide a bottom isolation and formation of a dielectric wall between said substacks (21,22).

2. A method according to claim 1, wherein said bottom semiconductor nanosheet (2a) comprises SiGe having a Ge content of over 50%.

3. A method according to claim 2, wherein said bottom semiconductor nanosheet (2a) is a Si_{0.35}Ge_{0.65} sheet.

4. A method according to claim 2 or 3, wherein the other semiconductor nanosheets of the stack comprises SiGe sheets having a Ge content of below 40%.

5. A method according to any previous claim, wherein the stack (2) formed in step a) comprises an upper insulator layer (5) above said semiconductor material sheets (2b).

6. A method according to claim 5, wherein the upper insulator layer (5) comprises Si₃N₄.

7. A method according to claim 5 or 6, wherein the stack (2) further comprises a top oxide layer (6).

8. A method according to any one of claims 5-7, wherein step a) further comprises lining said stack (2) with an insulator material (7) and depositing an STI oxide (8) conformally to the lined sidewalls (2c) of the stack (2), such that said stack (2) is held together by said STI oxide (8) during step c).

9. A method according to claim 8, wherein step b) comprises the steps of
b11) planarizing the formed structure after STI oxide deposition such that the upper insulator layer (5) above said semiconductor material sheets (2b) is the uppermost layer of the stack (2);
b12) forming a patterned photoresist layer (9) over the upper insulator layer (5) such that an opening (10) in said photoresist layer (9) is positioned vertically over the stack (2); and
b13) forming a trench (3) through said stack vertically down through said bottom semiconductor nanosheet (2a) at the position of said opening (10); thereby separating the stack (2) into two substacks (21,22).

10. A method according to claim 8, wherein step b) comprises
b21) planarizing the formed structure after STI oxide (8) deposition such that the upper insulator layer (5) above said semiconductor material sheets (2b) is the uppermost layer of the stack (2);
b22) removing said upper insulator layer (5) such that said deposited STI oxide (8) forms vertically extending sidewalls (8a) at the side of said stack (2);
b23) depositing spacer material (11) over said stack (2) and at the vertically extending sidewalls (8a), thereby defining a horizontal gap (12) over said stack (2); and
b24) forming a trench (3) through said stack vertically down through said bottom semiconductor nanosheet (2a) at the position of said horizontal gap (12); thereby separating the stack (2) into two substacks (21,22).

11. A method according to claim 8, wherein step a) further comprises trimming the sidewalls (5a) of said upper insulator layer (5) such that the upper insulator layer (5) has a width that is smaller than the width of the semiconductor material sheets (2b) of the stack (2), said trimming being performed before lining said stack (2) with an insulator material (7).

12. A method according to any previous claim, wherein the dielectric material (13) of step d) is selected from the group consisting of comprises Si₃N₄, SiCO and SiO₂.

13. A method according to any previous claim, wherein the method further comprises a step e) of planarizing the isolated substacks (21, 22) of step d).

14. A method according to any previous claim, wherein the method further comprises forming gates around the substacks (21,22).

15. A method according to claim 14, wherein the gate around a first substack (21) is a p-gate and wherein the gate around a second substack (22) is an n-gate.

## Patentansprüche

1. Verfahren zum Bilden eines Halbleiterbauelements (1), wobei das Verfahren folgende Schritte umfasst
a) Bilden, auf einer Substratfläche (20), eines Stapels (2) von horizontal gestapelten Nanofolien in der Form einer Finne, wobei der Stapel Halbleitermaterialfolien (2b) und eine untere Halbleiternanofolie (2a) umfasst;
b) Bilden eines Grabens (3) durch den Stapel (2) hindurch vertikal nach unten durch die untere Halbleiternanofolie (2a) hindurch; wodurch die Finne in zwei Teilfinnen und der Stapel in zwei Teilstapel (21, 22) getrennt wird;
c) selektives Entfernen der unteren Halbleiternanofolie (2a), wodurch ein unterer Raum (4) gebildet wird, der sich unter den Teilstapeln (21, 22) erstreckt;
d) gleichzeitiges Ausfüllen des unteren Raums (4) und des Grabens (3) mit dem gleichen dielektrischen Material (13), um eine untere Isolierung und die Bildung einer dielektrischen Wand zwischen den Teilstapeln (21, 22) bereitzustellen.

2. Verfahren nach Anspruch 1, wobei die untere Halbleiternanofolie (2a) SiGe umfasst, das einen Ge-Gehalt von mehr als 50 % aufweist.

3. Verfahren nach Anspruch 2, wobei die untere Halbleiternanofolie (2a) eine Si_{0,35}-Ge_{0,65}-Folie ist.

4. Verfahren nach Anspruch 2 oder 3, wobei die anderen Halbleiternanofolien des Stapels SiGe-Folien umfassen, die einen Ge-Gehalt von weniger als 40 % aufweisen.

5. Verfahren nach einem der vorhergehenden Ansprüche, wobei der in Schritt a) gebildete Stapel (2) eine obere Isolierschicht (5) über den Halbleitermaterialfolien (2b) umfasst.

6. Verfahren nach Anspruch 5, wobei die obere Isolierschicht (5) Si₃N₄ umfasst.

7. Verfahren nach Anspruch 5 oder 6, wobei der Stapel (2) ferner eine obere Oxidschicht (6) umfasst.

8. Verfahren nach einem der Ansprüche 5 bis 7, wobei Schritt a) ferner das Auskleiden des Stapels (2) mit einem Isoliermaterial (7) und das Abscheiden eines STI-Oxids (8) konform mit den ausgekleideten Seitenwänden (2c) des Stapels (2) umfasst, so dass der Stapel (2) durch das STI-Oxid (8) während Schritt c) zusammengehalten wird.

9. Verfahren nach Anspruch 8, wobei Schritt b) folgende Schritte umfasst
b11) Planarisieren der gebildeten Struktur nach der STI-Oxidabscheidung, so dass die obere Isolierschicht (5) über den Halbleitermaterialfolien (2b) die oberste Schicht des Stapels (2) ist;
b12) Bilden einer strukturierten Photoresistschicht (9) über der oberen Isolierschicht (5), so dass eine Öffnung (10) in der Photoresistschicht (9) vertikal über dem Stapel (2) positioniert ist; und
b13) Bilden eines Grabens (3) durch den Stapel hindurch vertikal nach unten durch die untere Halbleiterfolie (2a) hindurch in der Position der Öffnung (10); wodurch der Stapel (2) in zwei Teilstapel (21, 22) getrennt wird.

10. Verfahren nach Anspruch 8, wobei Schritt b) umfasst
b21) Planarisieren der gebildeten Struktur nach der STI-Oxidabscheidung (8), so dass die obere Isolierschicht (5) über den Halbleitermaterialfolien (2b) die oberste Schicht des Stapels (2) ist;
b22) Entfernen der oberen Isolierschicht (5), so dass das abgeschiedene STI-Oxid (8) sich vertikal erstreckende Seitenwände (8a) auf der Seite des Stapels (2) bildet;
b23) Abscheiden von Abstandsmaterial (11) über dem Stapel (2) und an den sich vertikal erstreckenden Seitenwänden (8a), wodurch eine horizontale Lücke (12) über dem Stapel (2) gebildet wird; und
b24) Bilden eines Grabens (3) durch den Stapel hindurch vertikal nach unten durch die untere Halbleiternanofolie (2a) hindurch in der Position der horizontalen Lücke (12), wodurch der Stapel (2) in zwei Teilstapel (21, 22) getrennt wird.

11. Verfahren nach Anspruch 8, wobei Schritt a) ferner das Zuschneiden der Seitenwände (5a) der oberen Isolierschicht (5) umfasst, so dass die obere Isolierschicht (5) eine Breite aufweist, die kleiner als die Breite der Halbleitermaterialfolien (2b) des Stapels (2) ist, wobei das Zuschneiden vor dem Auskleiden des Stapels (2) mit einem Isoliermaterial (7) ausgeführt wird.

12. Verfahren nach einem der vorhergehenden Ansprüche, wobei das dielektrische Material (13) aus Schritt d) aus der Gruppe ausgewählt wird, die aus Si₃N₄, SiCO und SiO₂ besteht.

13. Verfahren nach einem der vorhergehenden Ansprüche, wobei das Verfahren ferner einen Schritt e) des Planarisierens der isolierten Teilstapel (21, 22) aus Schritt d) umfasst.

14. Verfahren nach einem der vorhergehenden Ansprüche, wobei das Verfahren ferner das Bilden von Gates um die Teilstapel (21, 22) herum umfasst.

15. Verfahren nach Anspruch 14, wobei das Gate um einen ersten Teilstapel (21) herum ein p-Gate ist, und wobei das Gate um einen zweiten Teilstapel (22) herum ein n-Gate ist.

## Revendications

1. Procédé de formation d'un dispositif semiconducteur (1), ledit procédé comprenant les étapes de
a) formation, sur une surface de substrat (20), d'une pile (2) de nanofeuilles empilées horizontalement sous la forme d'une ailette, ladite pile comprenant des feuilles de matériau semiconducteur (2b) et une nanofeuille semiconductrice de base (2a) ;
b) formation d'une tranchée (3) à travers ladite pile (2) verticalement vers le bas à travers ladite nanofeuille semiconductrice de base (2a) ; en séparant ainsi l'ailette en deux sous-ailettes et la pile en deux sous-piles (21, 22) ;
c) élimination sélective de ladite nanofeuille semiconductrice de base (2a), en formant ainsi un espace de base (4) s'étendant sous lesdites sous-piles (21, 22) ;
d) remplissage simultané dudit espace de base (4) et de ladite tranchée (3) avec le même matériau diélectrique (13) pour assurer une isolation de la base et une formation d'une paroi diélectrique entre lesdites sous-piles (21, 22).

2. Procédé selon la revendication 1, dans lequel ladite nanofeuille semiconductrice de base (2a) comprend du SiGe ayant une teneur en Ge supérieure à 50%.

3. Procédé selon la revendication 2, dans lequel ladite nanofeuille semiconductrice de base (2a) est une feuille Si_{0.35}Ge_{0.65}.

4. Procédé selon la revendication 2 ou 3, dans lequel les autres nanofeuilles semiconductrices de la pile comprennent des feuilles SiGe ayant une teneur en Ge inférieure à 40%.

5. Procédé selon une quelconque des revendications précédentes, dans lequel la pile (2) formée à l'étape a) comprend une couche isolante supérieure (5) au-dessus desdites feuilles de matériau semiconducteur (2b).

6. Procédé selon la revendication 5, dans lequel la couche isolante supérieure (5) comprend du Si₃N₄.

7. Procédé selon la revendication 5 ou 6, dans lequel la pile (2) comprend en outre une couche d'oxyde supérieure (6).

8. Procédé selon une quelconque des revendications 5 à 7, dans lequel l'étape a) comprend en outre de revêtir ladite pile (2) d'un matériau isolant (7) et de déposer un oxyde STI (8) épousant parfaitement les parois latérales revêtues (2c) de la pile (2), de sorte que ladite pile (2) soit solidarisée par ledit oxyde STI (8) pendant l'étape c).

9. Procédé selon la revendication 8, dans lequel l'étape b) comprend les étapes de
b11) planarisation de la structure formée après le dépôt d'oxyde STI de sorte que la couche isolante (5) au-dessus desdites feuilles de matériau semiconducteur (2b) soit la couche la plus haute de la pile (2) ;
b12) formation d'une couche de résine photosensible structurée (9) au-dessus de la couche isolante supérieure (5) de sorte qu'une ouverture (10) dans ladite couche de résine photosensible (9) soit positionnée verticalement au-dessus de la pile (2) ; et
b13) formation d'une tranchée (3) à travers ladite pile verticalement vers le bas à travers ladite nanofeuille semiconductrice de base (2a) à la position de ladite ouverture (10) ; en séparant ainsi la pile (2) en deux sous-piles (21, 22).

10. Procédé selon la revendication 8, dans lequel l'étape b) comprend
b21) la planarisation de la structure formée après le dépôt d'oxyde STI (8) de sorte que la couche isolante supérieure (5) au-dessus desdites couches de matériau semiconducteur (2b) soit la couche la plus haute de la pile (2) ;
b22) l'élimination de ladite couche isolante supérieure (5) de sorte que ledit oxyde STI déposé (8) forme des parois latérales (8a) s'étendant verticalement sur les côtés de ladite pile (2) ;
b23) le dépôt d'un matériau d'espacement (11) au-dessus de ladite pile (2) et au niveau des parois latérales s'étendant verticalement (8a), en définissant ainsi un interstice horizontal (12) au-dessus de ladite pile (2) ; et
b24) la formation d'une tranchée (3) à travers ladite pile verticalement vers le bas à travers ladite nanofeuille semiconductrice de base (2a) à la position dudit interstice horizontal (12) ; en séparant ainsi la pile (2) en deux sous-piles (21, 22).

11. Procédé selon la revendication 8, dans lequel l'étape a) comprend en outre l'ébavurage des parois latérales (5a) de ladite couche isolante (5) de sorte que la couche isolante supérieure (5) ait une largeur qui soit plus petite que la largeur des feuilles de matériau semiconducteur (2b) de la pile (2), ledit ébavurage étant effectué avant le revêtement de ladite pile (2) avec un matériau isolant (7).

12. Procédé selon une quelconque des revendications précédentes, dans lequel le matériau diélectrique (13) de l'étape d) est sélectionné dans le groupe composé de Si₃N₄, SiCO et SiO₂.

13. Procédé selon une quelconque des revendications précédentes, dans lequel le procédé comprend en outre une étape e) de planarisation des sous-piles isolées (21, 22) de l'étape d).

14. Procédé selon une quelconque des revendications précédentes, dans lequel le procédé comprend en outre la formation de portes autour des sous-piles (21, 22).

15. Procédé selon la revendication 14, dans lequel la porte autour d'une première sous-pile (21) est une porte p et dans lequel la porte autour d'une deuxième sous-pile (22) est une porte n.
